# EUROPÄISCHE PATENTSCHRIFT

(11) **EP 2 018 701 B1**
(45) Veröffentlichungstag und Bekanntmachung des Hinweises auf die Patenterteilung: **02.12.2015**
(21) Anmeldenummer: 07725199.9
(22) Anmeldetag: 14.05.2007
(51) Int. Cl.: H03K 17/082, H03K 17/687

(54) **LEISTUNGSSCHALTUNG MIT KURZSCHLUSSSCHUTZSCHALTUNG**
POWER CIRCUIT WITH SHORT-CIRCUIT PROTECTIVE CIRCUIT
CIRCUIT INTÉGRÉ DE PUISSANCE AVEC CIRCUIT DE PROTECTION CONTRE LES COURTS-CIRCUITS

(30) Priorität: 12.05.2006 DE 102006022158
(43) Veröffentlichungstag der Anmeldung: 28.01.2009
(73) Patentinhaber: Beckhoff Automation GmbH, 33415 Verl (DE)
(72) Erfinder: PRÜSSMEIER, Uwe, 32657 Lemgo (DE)
(74) Vertreter: Wilhelm, Jürgen
(86) Internationale Anmeldenummer: PCT/EP2007/004280
(87) Internationale Veröffentlichungsnummer: WO 2007/131762

(56) Entgegenhaltungen:
- WO-A-95/07570
- DE-A1- 4 316 185
- GB-A- 2 158 314
- GB-A- 2 278 025
- US-A- 4 429 339
- US-A- 4 620 258
- US-A- 4 937 697

## Beschreibung

Die Erfindung betrifft eine Leistungsschaltung mit einem strombegrenzenden Halbleiterschalter und einer an den strombegrenzenden Halbleiterschalter angeschlossenen Steuerung zum Auf- und Zusteuern des Halbleiterschalters, wobei die Steuerung eine Kurzschlussschutzschaltung für den strombegrenzenden Halbleiterschalter aufweist.

Leistungshalbleiterschalter, die in der Lage sind, elektrische Ströme von über 1A zu schalten, zeichnen sich durch eine einfache Steuerung und hohe Lebensdauer aus, da sie keine zur Abnutzung neigenden Teile beinhalten. Solche Leistungshalbleiter werden insbesondere auch zum Schalten von Netzspannungen genutzt und als Dimmer eingesetzt, um stufenlos die Leistung von elektrischen Lampen, Leuchten oder Motoren zu regulieren.

Als Leistungshalbleiter werden neben Tyristoren und BipolarTransistoren vermehrt auch Feldeffekttransistoren verwendet, die sich durch ein schnelles Schaltverhalten auszeichnen. Von Vorteil bei Feldeffekttransistoren ist weiterhin der positive Temperaturkoeffizient, wodurch eine einfache Parallelschaltung zu realisieren ist. Als Leistungsfeldeffekttransistoren werden vor allem N-Kanal-Feldeffekttransistoren mit einer Driftstrecke im Bereich der Drain-Elektrode eingesetzt.

Feldeffekttransistoren lassen sich sowohl als Phasenan- als auch als Phasenabschnittsdimmer zur Steuerung der von einer Wechselspannungsquelle an einen Verbraucher abgegebenen Leistung betreiben. Bei der Phasenanschnittssteuerung wird die von der Wechselspannungsquelle an den Verbraucher abgegebene Leistung dadurch reduziert, dass der Anfang der positiven bzw. negativen Halbwelle der Wechselspannung entsprechend der zu steuernden Leistung abgeschnitten wird. Bei der Phasenabschnittssteuerung dagegen wird die Leistung im Verbraucher reduziert, in dem die Wechselspannung vom Nulldurchgang an entsprechend der zu steuernden Leistung verzögert zum Verbraucher durchgeschaltet bzw. vorzeitig wieder unterbrochen wird. Die Phasenabschnittssteuerung hat gegenüber der Phasenanschnittssteuerung den Vorteil, dass sich beim Einschalten keine steilen Spannungsflanken ergeben.

Leistungsschaltungen zum Schalten und Dimmen von Wechselspannungen mit Feldeffekttransistoren als Halbleiterschalter weisen in der Regel zwei in Reihe geschaltete N-Kanal-Feldeffekttransistoren mit einer Driftstrecke im Bereich der Drain-Elektrode auf, wobei die Source-Elektroden der beiden Feldeffekttransistoren miteinander verbunden sind. Die Drain-Elektrode des einen Feldeffekttransistors ist dann an die Wechselspannungsquelle, die Drain-Elektrode des anderen Feldeffekttransistors an den Verbraucher angeschlossen. Die Gate-Elektroden der beiden Feldeffekttransistoren sind mit einer Steuerung verbunden, die die Gate-Spannung regelt, um die Feldeffekttransistoren auf und zu zusteuern und so die von der Wechselspannung an den Verbraucher abgegebene Leistung zu regulieren.

Um die Leistungsschaltung mit den in Reihe angeordneten Feldeffekttransistoren kurzschlussfest zu machen, d. h., bei Auftreten eines Kurzschlusses im Verbraucher zu verhindern, dass dann die von der Wechselspannungsquelle angegebene Leistung durch Überhitzung die Feldeffekttransistoren beschädigt oder zerstört, weisen die Leistungsschaltungen in der Regel eine zusätzliche Kurzschlussschutzschaltung auf.

Zwei mögliche Ausbildungen einer solchen Kurzschlussschutzschaltung sind in der DE 698 08 044 T2 dargestellt. Gemäß der herkömmlicherweise verwendeten Schaltungsauslegung ist zum Erreichen der Kurzschlussfestigkeit zwischen den beiden Source-Elektroden der Feldeffekttransistoren ein zusätzlicher ohmscher Widerstand in den Strompfad geschaltet. Die mit den Gate-Elektroden der Feldeffekttransistoren verbundene Steuerung tastet den Spannungsabfall über diesen ohmschen Widerstand ab. Wenn der Spannungsabfall aufgrund eines Kurzschlusses im nachgeschalteten Verbraucher stark ansteigt, wird dieser Spannungsabfall von der Steuerung registriert und daraufhin dann die beiden Feldeffekttransistoren abgeschaltet. Diese herkömmliche Kurzschlussschutzschaltung führt aufgrund des zusätzlich in den Strompfad geschalteten ohmschen Widerstands zu einem ungewünschten Leistungsverlust.

Um einen solchen Leistungsverlust zu verhindern, wird in der DE 698 08 044 T2 eine Kurzschlussschutzschaltung für einen Phasenanschnittsbetrieb einer Leistungsschaltung mit zwei über die Source-Elektroden in Reihe geschalteten Feldeffekttransistoren vorgeschlagen, bei der zusätzliche Bauelemente zur Messung der Änderung der Gate-Elektroden-Potentiale bezogen auf die zwischen den Source-Elektroden und den Drain-Elektroden anliegenden Spannungen vorgesehen sind. Auf der Grundlage der Messergebnisse wird das Schalten der Feldeffekttransistoren in den leitenden Zustand dann entweder erlaubt oder verhindert. Diese bekannte Kurzschlussschutzschaltung ist jedoch aufwändig und nur im Rahmen einer Phasenanschnittssteuerung einsetzbar.

Aus der DE 198 42 045 A1 ist weiter eine Leistungsschaltung bekannt, die ein Halbleiterschaltelement z.B einen MOSFET aufweist, der im Normalbetrieb über seine Gate-Spannung bis zur maximal zulässigen Strombelastung voll aufgesteuert ist. Im Kurzschlussfall fließt dann sofort ein sehr hoher Strom mit der Gefahr einer Zerstörung des Halbleiterschaltelements. Um dem entgegenzuwirken, ist eine aufwendige Spannungsanstiegserkennungsschaltung vorgesehen, mit der das Halbleiterschaltelement mit einer Reaktionszeit von wenigen µsec abgeschaltet wird. Um ein ungewünschtes Abschalten des Halbleiterschaltelement aufgrund der schnellen Reaktionszeit der Spannungsanstiegserkennungsschaltung beim Einschalten, bei dem ein kurzzeitiger Spannungsanstieg auftritt, zu vermeiden, ist ferner ein zusätzliches Schaltungsteil notwendig, dass ein ungewünschtes Abschalten während des Einschaltvorgangs verhindert.

Aus der GB 2 278 025 A mit den Merkmalen des Oberbegriffs des Anspruch 1 bekannt. Aus der US 4,419,339 ein strombegrenzender Halbleiterschalter bekannt, der sich aus zwei in Reihe angeordnete Feldeffekttransistoren zusammen, die über ihre Source-Elektroden miteinander verbunden sind.

Aufgabe der vorliegenden Erfindung ist es, eine Leistungsschaltung mit einem Halbleiterschalter bereitzustellen, der sich durch eine einfache und zuverlässige Kurzschlussschutzschaltung zum Verhindern einer Beschädigung bzw. Zerstörung des Halbleiterschalters bei Kurzschlüssen im nachgeschalteten Verbraucher auszeichnet, ohne dass die KurzschlussSchutzschaltung zu zusätzlichen Leistungsverlusten führt.

Diese Aufgabe wird durch eine Leistungsschaltung gemäß Anspruch 1 gelöst. Bevorzugte Weiterbildungen sind in den abhängigen Ansprüchen angegeben.

Gemäß der Erfindung weist die Leistungsschaltung einen strombegrenzenden Halbleiterschalter und eine an den strombegrenzenden Halbleiterschalter angeschlossenen Steuerung zum Auf- und Zusteuern des Halbleiterschalters auf, wobei die Steuerung eine Kurzschlussschutzschaltung zum Erfassen und Bewerten des Spannungsabfalls über den strombegrenzenden Halbleiterschalter umfasst.

Durch den erfindungsgemäßen Einsatz eines strombegrenzenden Halbleiterschalters in der Leistungsschaltung und Erfassen und Bewerten des Spannungsabfalls über diesen strombegrenzenden Halbleiterschalter ist es möglich, im Falle eines Kurzschlusses im nachgeschalteten Verbraucher sowohl im Phasenanschnitts- als auch Phasenabschnittsbetrieb durch Abschalten des strombegrenzenden Halbleiterschalters bei einem erhöhten Spannungsabfall ein Beschädigen oder Zerstören des strombegrenzenden Halbleiterschalters zu verhindern. Die strombegrenzende Eigenschaft des Halbleiterschalters sorgt dabei dafür, dass im Kurzschlussfall des nachgeschalteten Verbrauchers ein Strom-Sättigungsbetrieb im Halbleiterschalter auftritt, der wiederum dazu führt, dass sich ein Sprung im Spannungsabfall über den strombegrenzenden Halbleiterschalter ergibt. Dieser Sprung im Spannungsabfall lässt sich auf einfache Weise erfassen und bewerten, um dann entsprechende Maßnahmen zum Schutz des Halbleiterschalters vorzunehmen.

Der strombegrenzende Halbleiterschalter ist als Feldeffekttransistor ausgelegt, wobei die Steuerung mit der Gate-Elektrode des Feldeffekttransistors zum Auf- oder Zusteuern des Feldeffekttransistors verbunden ist. Durch den Einsatz eines Feldeffekttransistors lässt sich ein schnelles Schalten der Leistungselektronik erreichen und insbesondere auch der positive Temperaturkoeffizient, der für einen thermischen Selbstschutz sorgt, ausnutzen.

Der Feldeffekttransistor wird ferner mit einer maximalen Gate-Spannung betrieben, die eine Strombegrenzung unterhalb der maximal zulässigen Strombelastung des Feldeffekttransistors zur Folge hat. Durch diese Auslegung der Leistungsschaltung wird gewährleistet, dass der Feldeffekttransistor eine ausreichende Reserve hinsichtlich der möglichen Strombelastung bei einem Kurzschluss besitzt. Er kann dann diesen Zustand eine vergleichsweise lange Zeit z.B. mehr als 100µsec ohne Schaden überstehen. Der Steuerung wird damit ausreichend Zeit gegeben, den Feldeffekttransistor rechtzeitig abzuschalten. Ferner kann auch ein ungewünschtes Abschalten des Feldeffekttransistors beim Einschalten, bei dem ein kurzzeitiger Spannungsanstieg auftritt, vermieden werden, da eine Kurzschlussbewertung durch die Steuerung entsprechend verzögert werden kann, ohne das der Feldeffekttransistor beschädigt wird. Zudem wird der Kurzschlussstrom im Netz begrenzt und kann in gewissen Grenzen eingestellt werden. Das schont andere Netzkomponenten und sorgt auch dafür, dass eine vorgeschaltete Sicherung nicht auslöst.

Der Wert der maximal zulässigen Strombelastung entspricht dabei wenigstens dem Dreifachen des Sättigungsstroms des Feldeffekttransistors.

Gemäß einer weiteren bevorzugten Ausführungsform weist die Kurzschlussschutzschaltung einen ohmschen Widerstand auf, der an die Drain-Elektrode des Feldeffekttransistors angeschlossen ist. Hierdurch wird eine einfache Auslegung der Kurzschlussschutzschaltung gewährleistet, da über den ohmschen Widerstand der Spannungsgrenzwert festgelegt werden kann, der von der Kurzschlussschutzschaltung als Vorliegen eines Kurzschlusses im Verbraucher bewertet wird.

Gemäß einer weiteren bevorzugten Ausführungsform dient die Leistungsschaltung zum Betrieb eines Verbrauchers mit einer Wechselspannung, wobei der strombegrenzende Halbleiterschalter zwei in Serie angeordnete, über die Source-Elektroden miteinander verbundene Feldeffekttransistoren aufweist, die parallel zu Source-Elektrode und Drain-Elektrode jedes der beiden Feldeffekttransistoren eine Diode aufweisen, die in Durchlassrichtung geschaltet ist. Durch diese Auslegung des Halbleiterschalters kann auf einfache Weise ein Phasenanschnitt- wie auch ein Phasenabschnittsbetrieb mit Kurzschlussschutz gewährleistet werden.

Die Erfindung wird anhand der beigefügten Zeichnungen näher erläutert. Es zeigen:
Fig. 1 eine Prinzipdarstellung einer erfindungsgemäßen Leistungssteuerung im Blockschaltbild; und
Fig. 2 eine Ausführungsform einer erfindungsgemäßen Leistungssteuerung.

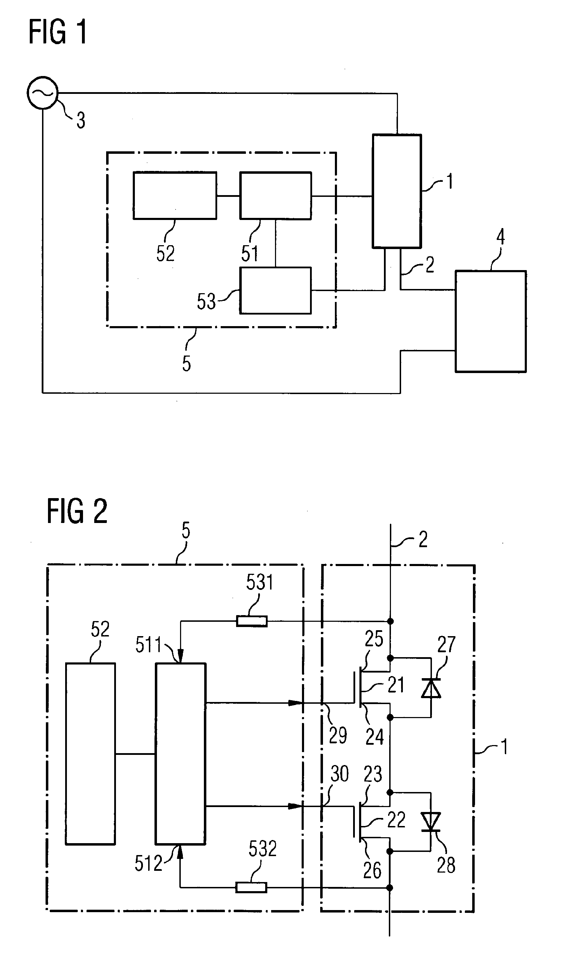

Fig. 1 zeigt vereinfacht eine erfindungsgemäße Leistungsschaltung zum Schalten und stufenlosen Regeln einer einem Verbraucher zugeführten Leistung. Die Leistungssteuerung eignet sich dabei zur Aussteuerung einer von einer Wechselspannungsquelle, insbesondere einer Netzspannungsquelle abgegebenen Leistung im Bereich von 0 bis 100 % der zur Verfügung gestellten Leistung. Die erfindungsgemäße Leistungssteuerung kann dabei sowohl im Phasenanschnitts- als auch im Phasenabschnittsbetrieb eingesetzt werden. Die erfindungsgemäße Leistungssteuerung lässt sich z. B. als Dimmer für einen Beleuchtungskörper einsetzen.

Die erfindungsgemäße Leistungssteuerung umfasst einen strombegrenzenden Halbleiterschalter 1, der in einen Strompfad 2 zwischen einer Spannungsquelle 3 und einem Verbraucher 4 geschaltet ist. Der strombegrenzende Halbleiterschalter 1 wird über eine Steuerung 5 zum Auf- und Zusteuern des strombegrenzenden Halbleiterschalters 1 betrieben. Die Steuerung 5 weist hierzu einen Mikrocontroller 51 auf, der mit eine Spannungsversorgung 52 verbunden ist, um Spannungsimpulse auf den strombegrenzenden Halbleiterschalter zum Auf- und Zusteuern abzugeben. Der dem Verbraucher 4 zugeführte elektrische Strom wird dabei durch den Arbeitszyklus des Mikrocontrollers 51 bestimmt, der das Verhältnis zwischen der Zeitdauer, in der der strombegrenzende Halbleiterschalter 1 leitend ist und somit Strom durchlässt, und der Zeitdauer, die der strombegrenzende Halbleiterschalter sperrt, vorgibt.

Um eine Beschädigung bzw. eine Zerstörung des strombegrenzenden Halbleiterschalters 1 durch einen Kurzschluss im Verbraucher 4 zu verhindern, weist die Steuerung eine Kurzschlussschutzschaltung 53 auf, die mit der strombegrenzenden Halbleiterschaltung 1 und dem Mikrocontroller 51 verbunden ist und den Spannungsabfall über den strombegrenzenden Halbleiterschalter 1 erfasst und bewertet. Der strombegrenzende Halbleiterschalter 1 ist dabei so dimensioniert, dass eine Strombegrenzung auch bei vollem Aufsteuern unterhalb der maximalen zulässigen Strombelastung erfolgt, so dass der strombegrenzende Halbleiterschalter 1 für einige zehn Mikrosekunden, vorzugsweise wenigstens 100 Mikrosekunden das Anliegen der vollen Versorgungsspannung übersteht.

Der strombegrenzende Halbleiterschalter ist weiterhin so ausgelegt, dass sein ohmscher Widerstand beim regulären Betrieb, d. h. beim Fließen des Nennstroms klein ist, was dazu führt, dass dann nur ein geringer Spannungsabfall auftritt. Bei einem Kurzschluss im Verbraucher steigt bei einem aufgesteuerten strombegrenzenden Halbleiterschalter dann der durch den Halbleiterschalter fließende elektrische Strom auf den Sättigungswert an, d. h., der strombegrenzende Halbleiterschalter wird zur Konstantstromquelle. Gleichzeitig erreicht der Spannungsabfall über den strombegrenzenden Halbleiterschalter den Wert der Versorgungsspannung, z. B. der Netzwechselspannung von 360 V. Dieser Anstieg des Spannungsabfalls über den strombegrenzenden Halbleiterschalter wird von der Kurzschlussschutzschaltung 53 erfasst, die daraufhin über den angeschlossenen Mikrocontroller 51 den strombegrenzenden Halbleiterschalter abschaltet und so vor einer Beschädigung oder Zerstörung schützt.

Der strombegrenzende Halbleiterschalter 1 ist als Feldeffekttransistor ausgeführt, bei dem die Source-Elektrode und die Drain-Elektrode in den Strompfad geschaltet sind und der Feldeffekttransistor über seine Gate-Elektrode durch den Mikrocontroller 51 der Steuerung 5 auf- und zugesteuert wird. Als Feldeffekttransistoren werden vorzugsweise N-Kanal-Feldeffekttransistoren mit einer Driftstrecke im Bereich der Drain-Elektrode eingesetzt.

Die Kurzschlussschutzschaltung wird dabei vorzugsweise von einem Widerstandselement gebildet, vorzugsweise einem hochohmigen Widerstandselement, das an die Drain-Elektrode des Feldeffekttransistors angeschlossen ist. Mit dieser Auslegung ist es dann möglich, dass eine Source-Drain-Spannung über einen Standard-Logikeingang ausgewertet wird. Ein Spannungspegel von z.B. über 2,5V wird als logische "1" von dem Mikrocontroller als ein Kurzschluss im Verbraucher erkannt, woraufhin der Mikrocontroller 51 dann den Feldeffekttransistor sperrt.

Fig. 2 zeigt eine Ausführungsform einer erfindungsgemäßen Leistungsschaltung, die sich vorzugsweise zum Schalten und stufenlosen Steuern einer Netzwechselspannung eignet. Der strombegrenzende Halbleiterschalter 1 setzt sich dabei aus zwei in Reihe angeordnete Feldeffekttransistoren 21, 22 zusammen, die über ihre Source-Elektroden 23, 24 miteinander verbunden sind. Die Drain-Elektrode 25 des ersten Feldeffekttransistors 21 ist an die Netzwechselspannungsquelle (nicht gezeigt) angeschlossen. Die Drain-Elektrode 26 des zweiten Feldeffekttransistors 22 ist mit dem Verbraucher (nicht gezeigt) verbunden. Parallel zu der Source-Elektrode und der Drain-Elektrode jedes der beiden Feldeffekttransistoren 21, 22 ist eine Diode 27, 28 in Durchlassrichtung geschaltet, die gewährleisten, dass die beiden Halbwellen der Netzwechselspannung optimal zur Leistungsversorgung des Verbrauchers genutzt werden.

Die Gate-Elektroden 29, 30 der beiden Feldeffekttransistoren 21, 22 sind mit dem Mikrocontroller 51 der Steuerung 5 verbunden, die die von der nachgeschalteten Spannungsversorgung 52 erzeugte Gate-Spannung auf die beiden Gate-Elektroden 29, 30 je nach gewünschter Leistungssteuerung durchschaltet. Die Kurzschlussschutzschaltung 53 weist zwei hochohmige Widerstände 531, 532 auf, die jeweils an die Interrupt-Eingänge 511, 512 des Mikrocontrollers 51 angeschlossen sind. Die beiden hochohmigen Widerstände 531, 532 sind weiter mit den Drain-Elektroden 25, 26 der Feldeffekttransistoren 21, 22 verbunden sind und vorzugsweise so ausgelegt, dass ein Spannungsabfall zwischen der Source-Elektrode und der Drain-Elektrode des zugeordneten Feldeffekttransistors, der die Gate-Spannung übersteigt, als logische "1" Zustand, der einen Kurzschluss anzeigt, vom Mikrocontroller 51 bewertet wird. Der Mikrocontroller 51 schaltet daraufhin die beiden Feldeffekttransistoren 21, 22 ab und schützt sie so vor einem Beschädigen bzw. Zerstören.

Die Feldeffekttransistoren 21, 22 weisen vorzugsweise jeweils einen kleinen Widerstand im durchgeschalteten Zustand auf, z. B. im Bereich von 100 mΩ. Dies führt dazu, dass für einen zu schaltenden Nennstrom im Bereich von 2A im durchgeschalteten Betrieb ein Spannungsabfall von 200 mV auftritt. Die Feldeffekttransistoren sind weiterhin vorzugsweise so dimensioniert, dass bei einer Gate-Spannung von 5 V ein Sättigungsstrom im Bereich von 10 A vorliegt, wobei die Feldeffekttransistoren Stromspitzen, die mindestens dem Dreifachen des Sättigungsstroms entsprechen, standhalten. Hierdurch wird für eine ausreichende Reserve bei einem Kurzschluss im nachgeschalteten Verbraucher gesorgt, so dass die Feldeffekttransistoren die volle Netzwechselspannung von 230 V wenigstens 100 µsec überstehen. In dieser Zeitspanne ist es der mit der erfindungsgemäßen Kurzschlussschutzschaltung versehenen Steuerung dann ohne Weiteres möglich, den Sprung im Spannungsabfall bei Auftreten eines Kurzschlusses zu erfassen und die Feldeffekttransistoren abzuschalten.

Durch den Einsatz eines strombegrenzenden Halbleiterschalters in einer Leistungsschaltung wird auf einfache Weise ein Kurzschlussschutz ohne Leistungsverbrauch ausschließlich durch Erfassen eines erhöhten Spannungsabfalls im Kurzschlussfall über den strombegrenzenden Halbleiterschalter ermöglicht.

## Patentansprüche

1. Leistungsschaltung mit
einem strombegrenzenden Halbleiterschalter (1), der wenigstens einen Feldeffekttransistor (21, 22) aufweist, und
einer an die Gate-Elektrode (29, 30) des Feldeffekttransistors (21, 22) angeschlossenen Steuerung (5) zum Auf- und Zusteuern des Feldeffekttransistors (21, 22) durch Anlegen einer Gate-Spannung, um einen Nennstrom über den Feldeffekttransistor (21, 22) zu schalten, der unterhalb eines Sättigungsstroms des Feldeffekttransistors (21, 22) liegt,
wobei die Steuerung (5) weiter eine Kurzschlussschutzschaltung (53) zum Erfassen und Bewerten des Spannungsabfalls über den Feldeffekttransistor (21, 22) aufweist,
wobei die von der Steuerung (5) an den Feldeffekttransistor (21, 22) angelegte maximale Gate-Spannung so dimensioniert ist, dass eine Strombegrenzung mit dem Sättigungsstrom bei vollem Aufsteuern des Feldeffekttransistors (21, 22) mit der maximalen Gate-Spannung unterhalb einer maximalen zulässigen Strombelastung des Feldeffekttransistor (21, 22) erfolgt,
**dadurch gekennzeichnet, dass**
der Wert der maximal zulässigen Strombelastung des Feldeffekttransistors (21, 22) wenigstens dem dreifachen Sättigungsstrom des Feldeffekttransistors entspricht, und wobei die Kurzschlussschutzschaltung (53) ausgelegt ist, einen Sprung im Spannungsabfall über den Feldeffekttransistor (21, 22) im Strom-Sättigungsbetrieb als Kurzschluss zu werten und den Feldeffekttransistor zu sperren.

2. Leistungsschaltung nach Anspruch 1, **dadurch gekennzeichnet, dass** die Kurzschlussschutzschaltung (53) ein Widerstandselement (531, 532) aufweist, das an die Drain-Elektrode (25, 26) des Feldeffekttransistors (21, 22) angeschlossen ist.

3. Leistungsschaltung nach Anspruch 1 oder 2 zum Anschluss an eine Wechselspannungsquelle, **dadurch gekennzeichnet, dass** der strombegrenzenden Halbleiterschalter (1) zwei in Serie angeordnete, über die Source-Elektroden (23, 24) miteinander verbundene Feldeffekttransistoren (21, 22) aufweist, wobei parallel zu Source-Elektrode und Drain-Elektrode jedes der beiden Feldeffekttransistoren eine Diode (27, 28) in Durchlassrichtung geschaltet ist.

4. Leistungsschaltung nach Anspruch 3, **dadurch gekennzeichnet, dass** die Kurzschlussschutzschaltung (53) zwei hochohmige Widerstände (531, 532) aufweist, wobei die beiden hochohmigen Widerstände (531, 532) jeweils mit einer Drain-Elektrode (25, 26) der Feldeffekttransistoren (21, 22) und einem Interrupt-Eingang (511, 512) eines Mikrocontrollers (51) der Steuerung (5) verbunden und ausgelegt sind, einen Spannungsabfall zwischen der Source-Elektrode und der Drain-Elektrode des zugeordneten Feldeffekttransistors, der die Gate-Spannung übersteigt, anzuzeigen, der vom Mikrocontroller (51) als Kurzschluss bewertet wird.

## Claims

1. Power circuit having
a current-limiting semiconductor switch (1), which has at least one field effect transistor (21, 22), and
a controller (5) which is connected to the gate electrode (29, 30) of the field effect transistor (21, 22) and is intended to turn the field effect transistor (21, 22) on and off by applying a gate voltage in order to switch a nominal current via the field effect transistor (21, 22), which nominal current is below a saturation current of the field effect transistor (21, 22),
the controller (5) also having a short-circuit protective circuit (53) for recording and assessing the voltage drop across the field effect transistor (21, 22),
the maximum gate voltage applied to the field effect transistor (21, 22) by the controller (5) being dimensioned in such a manner that current limitation with the saturation current is carried out, when the field effect transistor (21, 22) with the maximum gate voltage is fully turned on, below a maximum permissible current load of the field effect transistor (21, 22),
**characterized in that**
the value of the maximum permissible current load of the field effect transistor (21, 22) corresponds to at least three times the saturation current of the field effect transistor, and the short-circuit protective circuit (53) being designed to classify a sudden change in the voltage drop across the field effect transistor (21, 22) in the current saturation mode as a short circuit and to turn off the field effect transistor.

2. Power circuit according to Claim 1, **characterized in that** the short-circuit protective circuit (53) has a resistance element (531, 532) which is connected to the drain electrode (25, 26) of the field effect transistor (21, 22).

3. Power circuit according to Claim 1 or 2 for connection to an AC voltage source, **characterized in that** the current-limiting semiconductor switch (1) has two field effect transistors (21, 22) which are arranged in series and are connected to one another via the source electrodes (23, 24), a forward-biased diode (27, 28) being connected in parallel with the source electrode and drain electrode of each of the two field effect transistors.

4. Power circuit according to Claim 3, **characterized in that** the short-circuit protective circuit (53) has two high-value resistors (531, 532), the two high-value resistors (531, 532) each being connected to a drain electrode (25, 26) of the field effect transistors (21, 22) and to an interrupt input (511, 512) of a microcontroller (51) of the controller (5) and being designed to indicate a voltage drop between the source electrode and the drain electrode of the associated field effect transistor, which voltage drop exceeds the gate voltage and is assessed by the microcontroller (51) as a short circuit.

## Revendications

1. Circuit de puissance comportant
un commutateur à semi-conducteur limiteur de courant (1) comprenant au moins un transistor à effet de champ (21, 22) et une unité de commande (5) reliée à l'électrode de grille (29, 30) du transistor à effet de champ (21, 22) pour rendre passant et non passant le transistor à effet de champ (21, 22) par application d'une tension de grille afin de commuter à travers le transistor à effet de champ (21, 22) un courant nominal qui est inférieur à un courant de saturation du transistor à effet de champ (21, 22),
dans lequel l'unité de commande (5) comprend en outre un circuit de protection contre les courts-circuits (53) destiné à détecter et interpréter la chute de tension à travers le transistor à effet de champ (21, 22),
dans lequel la tension de grille maximale appliquée par l'unité de commande (5) au transistor à effet de champ (21, 22) est dimensionnée de manière à ce qu'une limitation du courant se produise avec le courant de saturation lorsque le transistor à effet de champ (21, 22) est attaqué de manière maximale avec la tension de grille maximale en dessous d'une charge de courant maximale admissible du transistor à effet de champ (21, 22),
**caractérisé en ce que** la valeur de la charge de courant maximale admissible du transistor à effet de champ (21, 22) correspond au moins au triple du courant de saturation du transistor à effet de champ et dans lequel le circuit de protection contre les courts-circuits (53) est conçu pour interpréter un saut de chute de tension à travers le transistor à effet de champ (21, 22) lors d'un fonctionnement à saturation du courant comme étant un court-circuit et pour rendre non passant le transistor à effet de champ.

2. Circuit de puissance selon la revendication 1, **caractérisé en ce que** le circuit de protection contre les courts-circuits (53) comprend un élément résistif (531, 532) qui est relié à l'électrode de drain (25, 26) du transistor à effet de champ (21, 22).

3. Circuit de puissance selon la revendication 1 ou 2 destiné à être relié à une source de tension alternative, **caractérisé en ce que** le commutateur à semi-conducteur limiteur de courant (1) comprend deux transistors à effet de champ (21, 22) agencés en série et connectés l'un à l'autre par l'intermédiaire des électrodes de source (23, 24), dans lequel une diode (27, 28) est connectée en sens passant en parallèle avec l'électrode de source et l'électrode de drain de chacun des deux transistors à effet de champ.

4. Circuit de puissance selon la revendication 3, **caractérisé en ce que** le circuit de protection contre les courts-circuits (53) comprend deux résistances de valeur élevée (531, 532), dans lequel les deux résistances de valeur élevée (531, 532) sont respectivement connectées à une électrode de drain (25, 26) des transistors à effet de champ (21, 22) et à une entrée d'interruption (511, 512) d'un microcontrôleur (51) de l'unité de commande (5) et sont conçues pour signaler une chute de tension entre l'électrode de source et l'électrode de drain du transistor à effet de champ associé dépassant la tension de grille, que le microcontrôleur (51) interprète comme étant un court-circuit.
